# EUROPEAN PATENT APPLICATION

(11) **EP 4 579 751 A1**
(43) Date of publication of application: **02.07.2025**
(21) Application number: 23857183.0
(22) Date of filing: 08.08.2023
(51) Int. Cl.: H01L 27/146, H04N 25/59, H04N 25/771

(54) **SOLID-STATE IMAGING DEVICE**

(30) Priority: 22.08.2022 JP 2022131496
(71) Applicant: Sony Semiconductor Solutions Corporation, Atsugi-shi, Kanagawa 243-0014 (JP)
(72) Inventor: YAMANAKA, Takaya, Atsugi-shi, Kanagawa 243-0014 (JP)
(74) Representative: Müller Hoffmann & Partner
(86) International application number: PCT/JP2023/028856
(87) International publication number: WO 2024/043069

(57) **Abstract**

The present disclosure relates to a solid-state imaging device that achieves desired characteristics with a more appropriate layout.

Provided is a solid-state imaging device that includes: a plurality of pixels that each include a photoelectric conversion element and a plurality of wiring capacitive elements; and a read-out unit that reads out signals from the plurality of pixels, the solid-state imaging device has a structure that a charge having overflown from the photoelectric conversion element is stored in a first wiring capacitive element, and the charge having overflown from the first wiring capacitive element is stored in a second wiring capacitive element, and the read-out unit individually reads out a signal of each of the photoelectric conversion element, the first wiring capacitive element, and the second wiring capacitive element. The present disclosure may be applied to, for example, a CMOS type solid-state imaging device.

## Description

### [Technical Field]

The present disclosure relates to a solid-state imaging device and, more particularly, relates to a solid-state imaging device that achieves desired characteristics with a more appropriate layout.

### [Background Art]

As a structure of a pixel of an image sensor, there is known a structure that is provided with a storage capacitance that stores charges having overflown from a photodiode (see, for example, PTL 1 and PTL 2).

PTL 1 discloses a structure of a pixel that is provided with a capacitance including a cylinder type capacitor as the storage capacitance that stores charges having overflown from the photodiode. PTL 2 discloses a structure of a pixel that is provided with a first storage capacitance and a second storage capacitance that store charges having overflown from photodiodes on the same plane as that of the photodiode.

### [Citation List]

### [Patent Literature]

[PTL 1]
   JP 2020-129795A
[PTL 2]
   JP 2006-245522A

### [Summary]

### [Technical Problem]

Although the storage capacitance is disposed as a one-storage structure in the structure disclosed in PTL 1, it is concerned that increasing an intra-pixel capacitance to expand a dynamic range lowers conversion efficiency, and therefore random noise deteriorates. Therefore, it is necessary to limit the intra-pixel capacitance to make an SN ratio a certain criterion or more, and it is difficult to balance between the intra-pixel capacitance and the dynamic range.

On the other hand, the storage capacitances are disposed as a two-stage structure in the structure disclosed in PTL 2 to achieve a wider dynamic range while keeping the SN ratio, two storage capacitances are disposed on the same plane as that of the photodiode, and therefore an area of a plane on a light incidence surface side of the photodiode is limited. Hence, a technique for achieving desired characteristics with a more appropriate layout is demanded.

With such circumstances in view, the present disclosure achieves desired characteristics with a more appropriate layout.

### [Solution to Problem]

A solid-state imaging device according to a first aspect of the present disclosure includes: a plurality of pixels that each include a photoelectric conversion element and a plurality of wiring capacitive elements; and a read-out unit that reads out signals from the plurality of pixels, the solid-state imaging device has a structure that a charge having overflown from the photoelectric conversion element is stored in a first wiring capacitive element, and the charge having overflown from the first wiring capacitive element is stored in a second wiring capacitive element, and the read-out unit individually reads out a signal of each of the photoelectric conversion element, the first wiring capacitive element, and the second wiring capacitive element.

The solid-state imaging device according to the first aspect of the present disclosure has the structure that the charge having overflown from the photoelectric conversion element is stored in the first wiring capacitive element, and the charge having overflown from the first wiring capacitive element is stored in the second wiring capacitive element, and individually reads out the signal of each of the photoelectric conversion element, the first wiring capacitive element, and the second wiring capacitive element.

A solid-state imaging device according to a second aspect of the present disclosure includes: a plurality of pixels that each include a plurality of photoelectric conversion elements and a plurality of wiring capacitive elements; and a read-out unit that reads out signals from the plurality of pixels, the solid-state imaging device has a structure that a first wiring capacitive element and a second wiring capacitive element are respectively connected to floating diffusions of a first photoelectric conversion element and a second photoelectric conversion element, and a charge having overflown from the first photoelectric conversion element is stored in the first wiring capacitive element, and the charge having overflown from the second photoelectric conversion element is stored in the second wiring capacitive element, and the read-out unit individually reads out a signal of each of the first photoelectric conversion element, the second photoelectric conversion element, the first wiring capacitive element, and the second wiring capacitive element.

The solid-state imaging device according to the second aspect of the present disclosure has the structure that the charge having overflown from the first photoelectric conversion element is stored in the first wiring capacitive element, and the charge having overflown from the second photoelectric conversion element is stored in the second wiring capacitive element, and individually reads out the signal of each of the first photoelectric conversion element, the second photoelectric conversion element, the first wiring capacitive element, and the second wiring capacitive element.

Note that the solid-state imaging device according to one aspect of the present disclosure may be an independent device or may be an internal block constituting one device.

### [Brief Description of Drawings]

[Fig. 1]

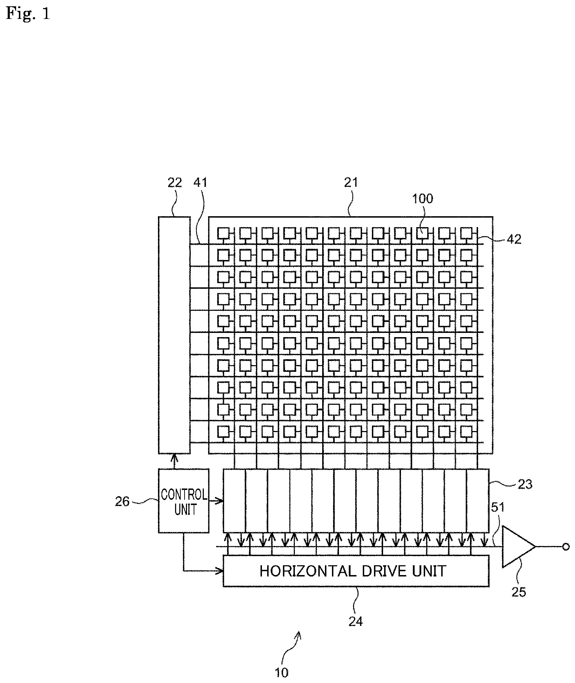

   Fig. 1 is a diagram illustrating a configuration example of one embodiment of a solid-state imaging device to which the present disclosure is applied.
[Fig. 2]

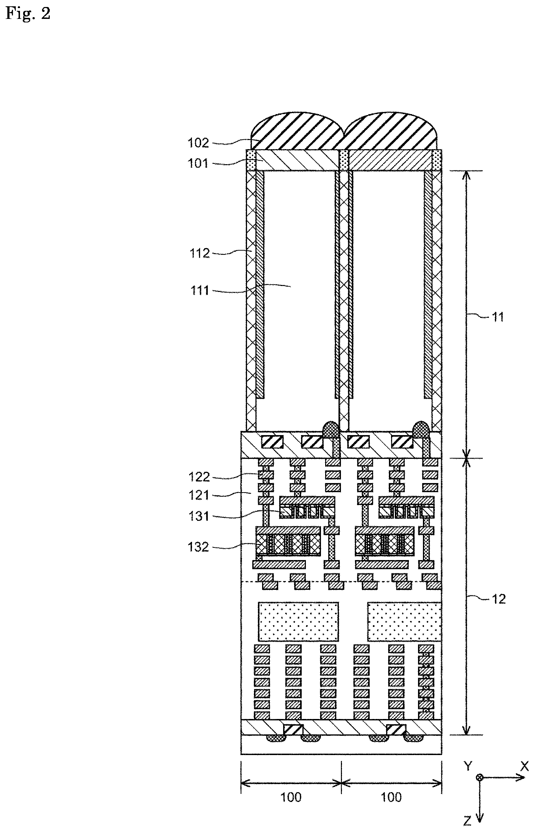

   Fig. 2 is a cross-sectional view illustrating a first example of a structure of a pixel.
[Fig. 3]

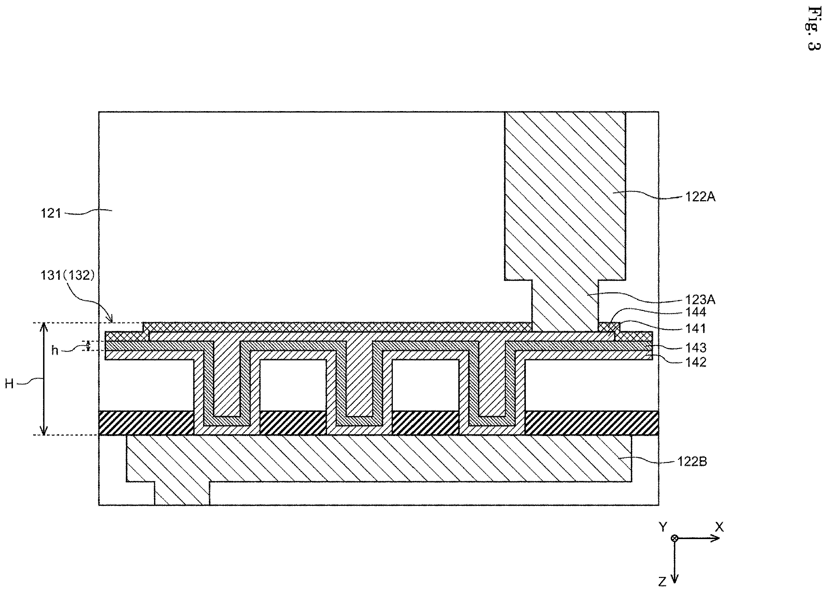

   Fig. 3 is a cross-sectional view illustrating an example of a structure of an MIM capacitive element.
[Fig. 4]

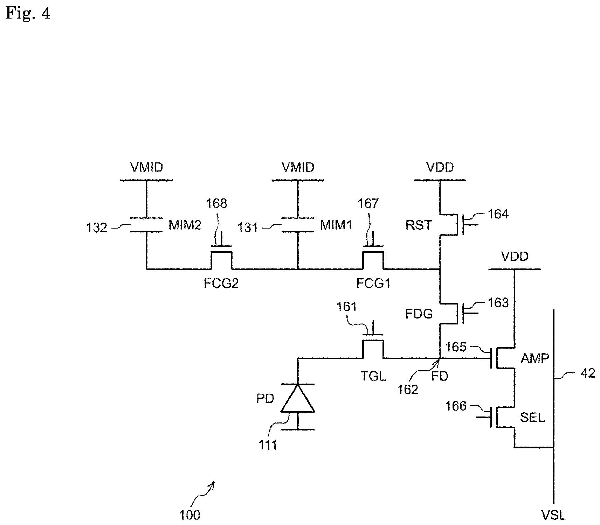

   Fig. 4 is a diagram illustrating a first example of a TG type circuit configuration of a pixel.
[Fig. 5]

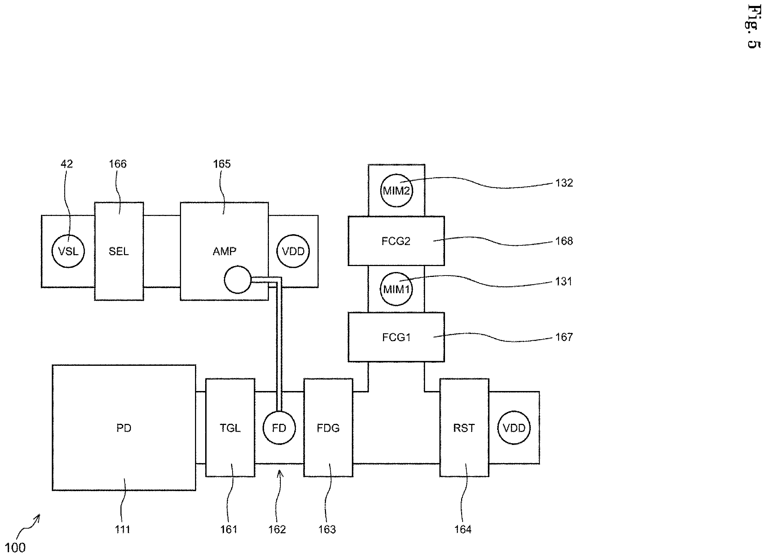

   Fig. 5 is a plan view corresponding to the TG type circuit configuration of the pixel in Fig. 4.
[Fig. 6]

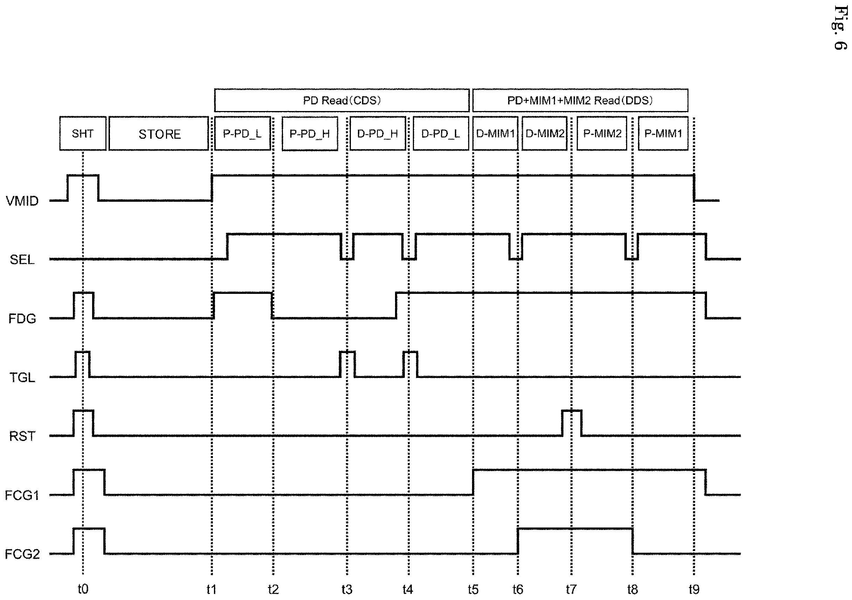

   Fig. 6 is a timing chart illustrating an example of a read-out operation of the circuit configuration of the pixel in Fig. 4.
[Fig. 7]

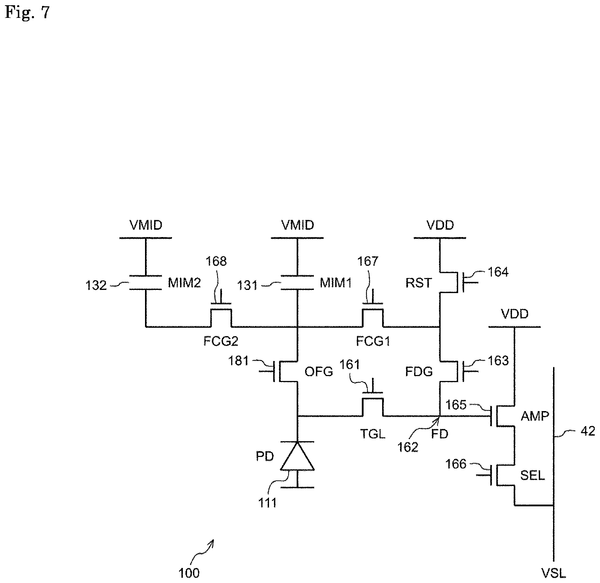

   Fig. 7 is a diagram illustrating a first example of an OFG type circuit configuration of a pixel.
[Fig. 8]

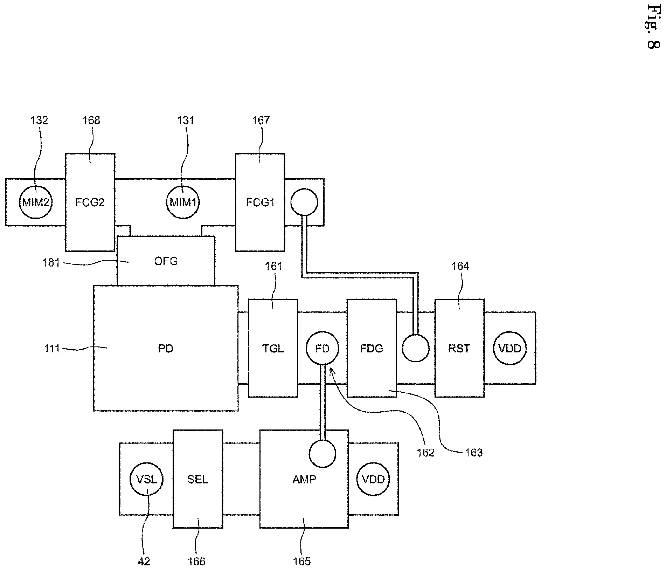

   Fig. 8 is a plan view corresponding to the OFG type circuit configuration of the pixel in Fig. 7.
[Fig. 9]

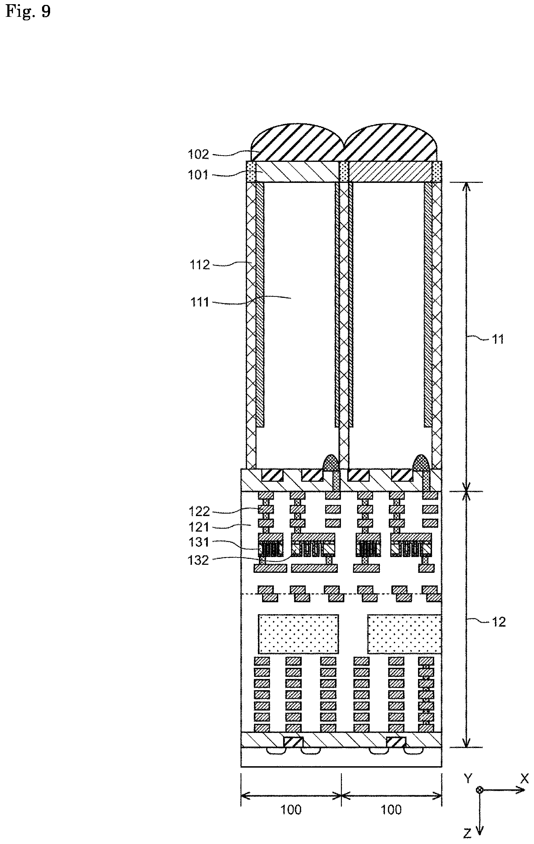

   Fig. 9 is a cross-sectional view illustrating a second example of the structure of the pixel.
[Fig. 10]

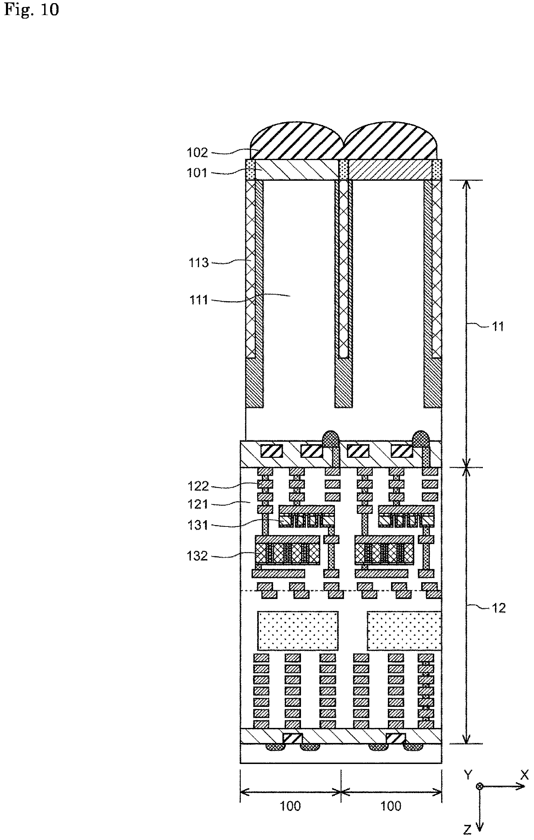

   Fig. 10 is a cross-sectional view illustrating a third example of the structure of the pixel.
[Fig. 11]

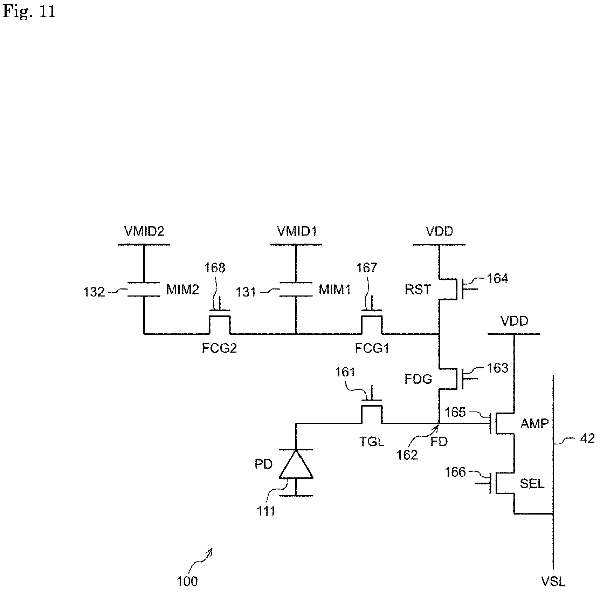

   Fig. 11 is a diagram illustrating a second example of the TG type circuit configuration of the pixel.
[Fig. 12]

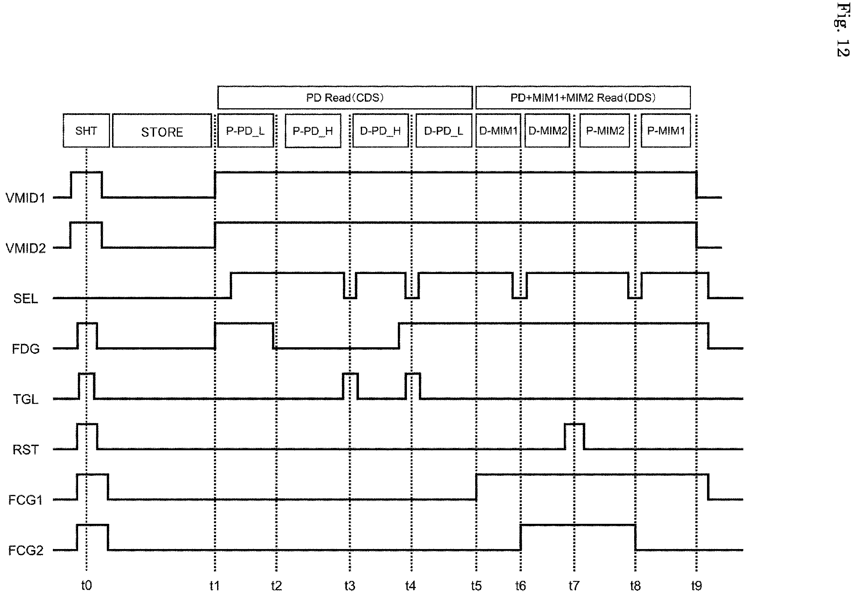

   Fig. 12 is a timing chart illustrating an example of a read-out operation of the circuit configuration of the pixel in Fig. 11.
[Fig. 13]

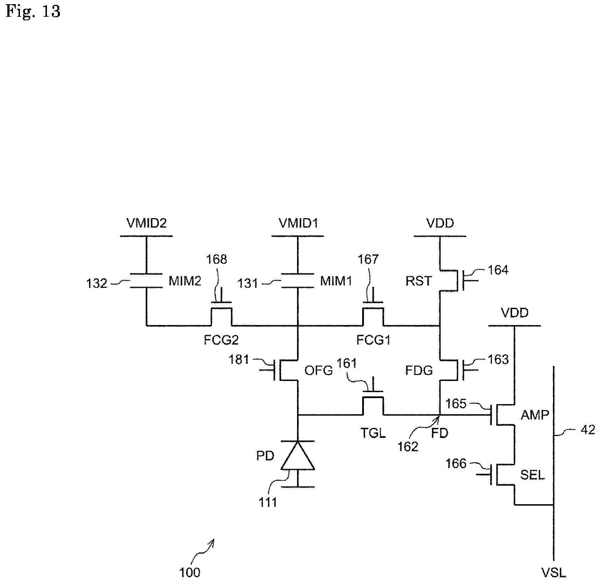

   Fig. 13 is a diagram illustrating a second example of the OFG type circuit configuration of the pixel.
[Fig. 14]

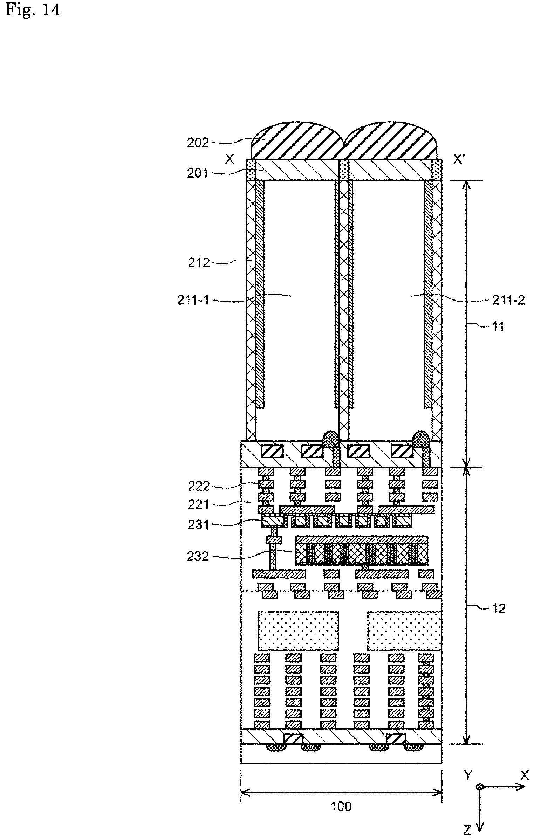

   Fig. 14 is a cross-sectional view illustrating another example of the structure of the pixel.
[Fig. 15]

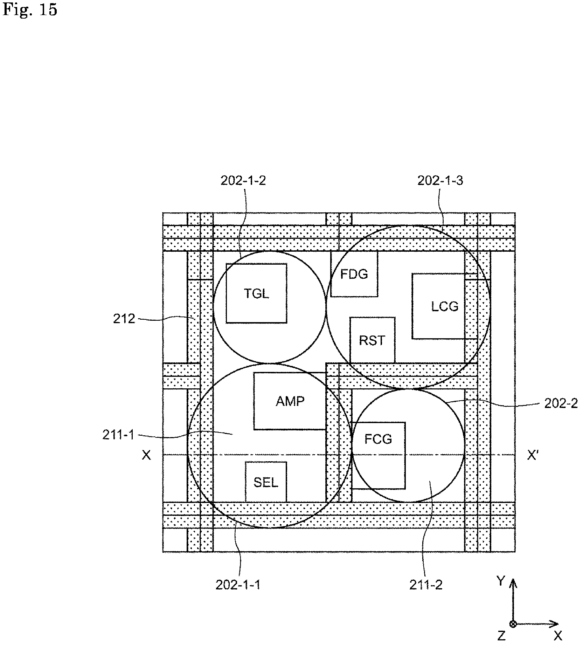

   Fig. 15 is a plan view corresponding to the pixel in Fig. 14.
[Fig. 16]

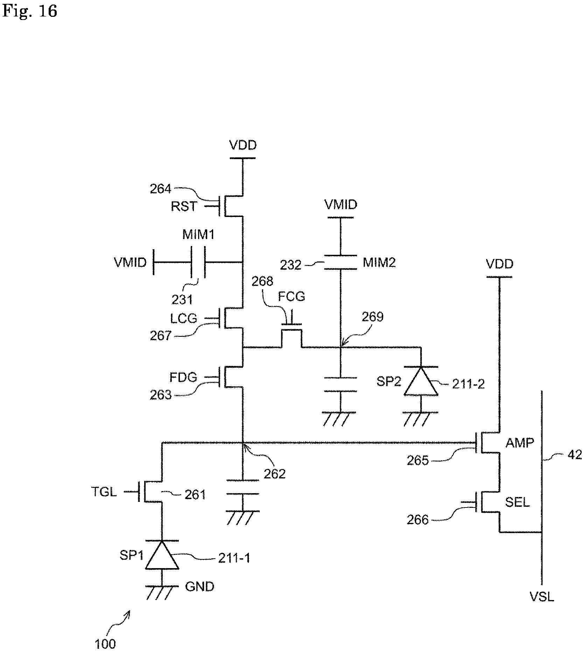

   Fig. 16 is a diagram illustrating an example of the circuit configuration of the pixel in Fig. 14.
[Fig. 17]

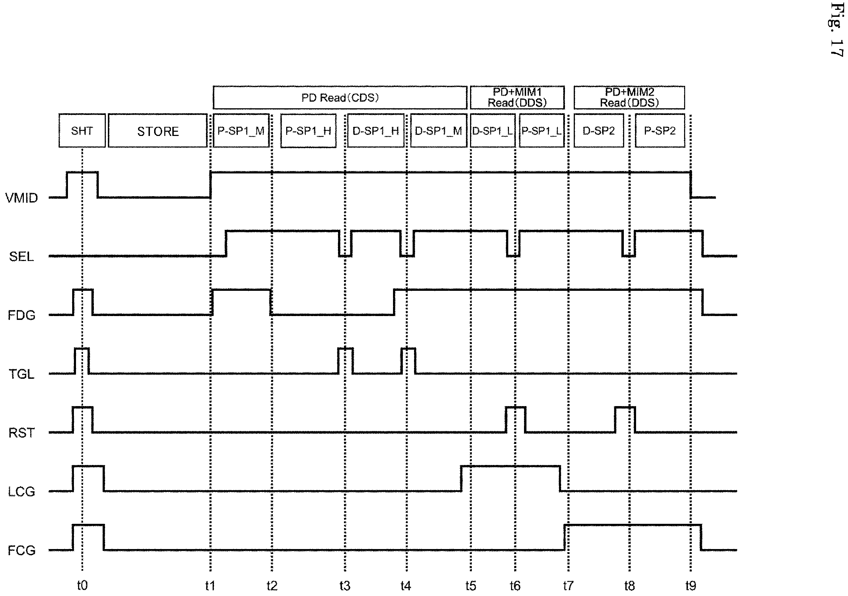

   Fig. 17 is a timing chart illustrating an example of a read-out operation of the circuit configuration of the pixel in Fig. 16.
[Fig. 18]

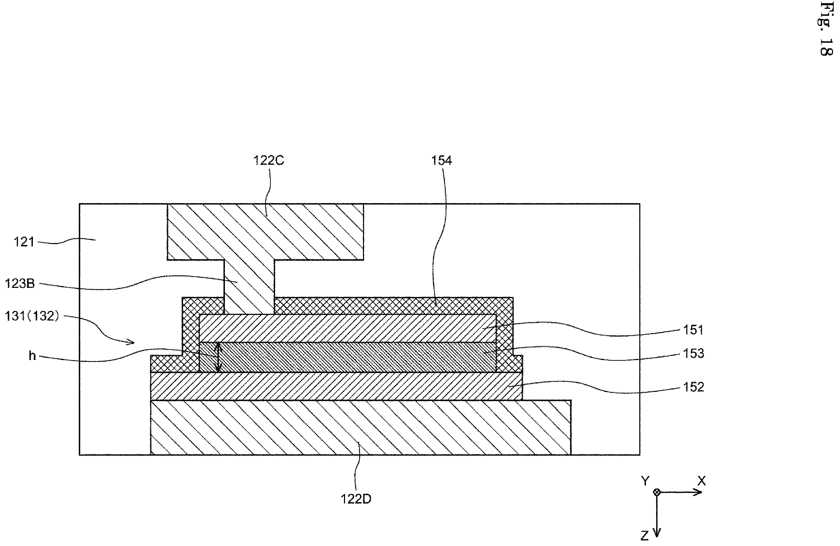

   Fig. 18 is a cross-sectional view illustrating another example of a structure of an MIM capacitive element.
[Fig. 19]

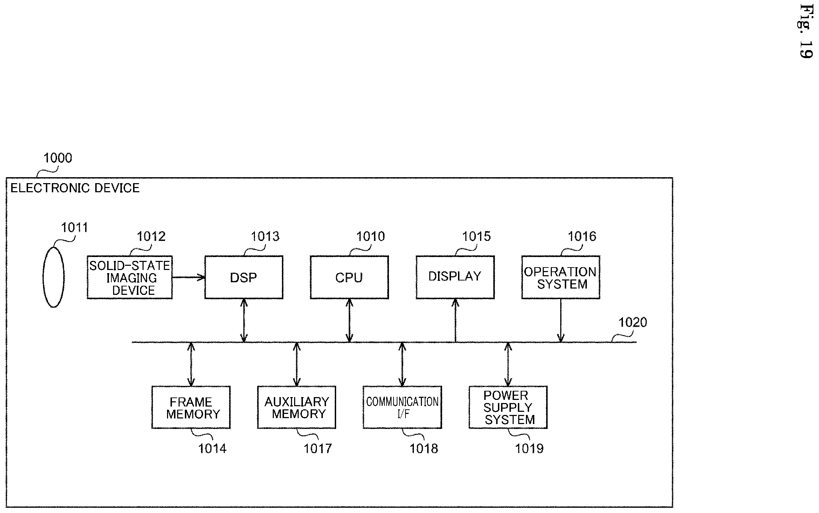

   Fig. 19 is a block diagram illustrating a configuration example of an electronic device including the built-in solid-state imaging device to which the present disclosure is applied.

### [Description of Embodiments]

### <Device Configuration>

Fig. 1 is a diagram illustrating a configuration example of one embodiment of a solid-state imaging device to which the present disclosure is applied.

In Fig. 1, a solid-state imaging device 10 is a Complementary Metal Oxide Semiconductor (CMOS) type solid-state imaging device. The solid-state imaging device 10 includes a pixel array unit 21, a vertical drive unit 22, a column signal processing unit 23, a horizontal drive unit 24, an output unit 25, and a control unit 26.

The pixel array unit 21 includes a plurality of pixels 100 two-dimensionally aligned in a matrix on a semiconductor substrate made of silicon (Si) or the like. The pixel 100 includes a photodiode, a plurality of pixel transistors, and the like. In the pixel array unit 21, a pixel drive line 41 is formed per row and connected to the vertical drive unit 22, and a vertical signal line 42 is formed per column and is connected to the column signal processing unit 23 for the plurality of pixels 100 two-dimensionally aligned in the matrix.

The vertical drive unit 22 is configured as a shift register, an address decoder, or the like, and drives each pixel 100 aligned in the pixel array unit 21. A signal output from each pixel 100 selected and scanned by the vertical drive unit 22 is supplied to the column signal processing unit 23 through the vertical signal line 42.

The column signal processing unit 23 performs predetermined signal processing (e.g. noise canceling processing or sampling processing) on the signal output from each pixel 100 of the selected row through the vertical signal line 42 per pixel column of the pixel array unit 21, and temporarily holds the signal after the signal processing.

The horizontal drive unit 24 is configured as a shift register, an address decoder, or the like, and sequentially selects unit circuits corresponding to the pixel columns of the column signal processing unit 23. By selection and scanning performed by the horizontal drive unit 24, signals subjected to signal processing by the column signal processing unit 23 are output to the output unit 25 through the horizontal signal line 51.

The output unit 25 performs predetermined signal processing on the signals sequentially input from the respective column signal processing units 23 through the horizontal signal line 51, and outputs the resulting signals.

The control unit 26 includes a timing generator or the like that generates various timing signals, and controls of driving of the vertical drive unit 22, the column signal processing unit 23, the horizontal drive unit 24, and the like based on the various timing signals generated by the timing generator.

Next, a first configuration to a fifth configuration will be described as configurations of the pixels 100 two-dimensionally aligned in the pixel array unit 21, and a read-out unit that reads out the signals from the plurality of pixels 100 in the solid-state imaging device 10. The read-out unit includes, for example, the vertical drive unit 22, the column signal processing unit 23, and the control unit 26.

### <First Configuration>

Fig. 2 is a cross-sectional view illustrating a first example of the structure of the pixel 100. In Fig. 2, in the three directions orthogonal to each other in a space, a first direction and a second direction orthogonal to each other in the same plane are an X direction and a Y direction, respectively, and a third direction orthogonal to each of the first direction and the second direction is a Z direction. Finally, in Fig. 2, a thickness direction of each layer will be described as the Z direction. The same also applies to other figures to be described later.

Each pixel 100 is formed by laminating a semiconductor layer 11 and a wiring layer 12. A color filter 101 and an on-chip microlens 102 are disposed on a light incident surface side of the semiconductor layer 11. The color filter 101 and the on-chip microlens 102 are provided per pixel 100. The color filter 101 is configured as a filter that allows transmission of a wavelength corresponding to, for example, one of Red (R), Green (G), and Blue (B).

A photodiode 111 is formed on a semiconductor substrate made of silicon (Si) or the like in the semiconductor layer 11. For example, the semiconductor substrate includes a P well layer in part of a top surface and an area near the top surface, and includes an N-type region whose conductive type is different from that of the P well layer in other regions. Thus, the photodiode 111 is formed as a photoelectric conversion element. Each pixel 100 is electrically and optically isolated by an inter-pixel isolation part 112. The inter-pixel isolation part 112 is formed by burying a metal film, an insulating film, or the like in a trench formed by penetrating the semiconductor substrate from a surface on a side opposite to the light incidence surface.

The wiring layer 12 is a multilayer wiring layer that includes plurality of wiring layers obtained by being stacked at a plurality of stages and forming a wiring 122 in each stage with an inter-wiring layer film 121 interposed therebetween. The inter-wiring layer film 121 is formed as a film for which a material such as a silicon oxide (SiO2) is used. The wiring 122 is formed with copper (Cu) or the like. In the wiring layer 12, a Metal Insulator Metal (MIM) capacitive element 131 and an MIM capacitive element 132 are disposed as wiring capacitive elements having different capacitances between the wiring layers.

The MIM capacitive element 131 and the MIM capacitive element 132 are provided per pixel 100. The MIM capacitive element 131 and the MIM capacitive element 132 are disposed so that at least a part of each other overlap on a plane in an X and Y directions. Furthermore, the MIM capacitive element 132 is disposed at a position deeper than that of the MIM capacitive element 131 in the Z direction, and is disposed between different wiring layers. That is, the MIM capacitive element 131 is disposed between first wiring layers, and the MIM capacitive element 132 is disposed between second wiring layers in the wiring layer 12.

The MIM capacitive element 131 stores charges having overflown from the photodiode 111. The MIM capacitive element 132 stores a charge having overflown from the MIM capacitive element 131. This structure makes it possible to store in the MIM capacitive element 131 and the MIM capacitive element 132 the charges having overflown from the photodiode 111 together with the charges stored in the photodiode 111, and read out the charges.

Fig. 3 is a cross-sectional view illustrating an example of the structure of the MIM capacitive element 131. In Fig. 3, the MIM capacitive element 131 has a three-dimensional structure in the X, Y, and Z directions. The MIM capacitive element 131 has the structure formed by laminating an upper electrode 141, a lower electrode 142, and a dielectric 143 sandwiched between the upper electrode 141 and the lower electrode 142. A cap film 144 is formed on the upper surface of the upper electrode 141. The upper electrode 141 is connected with a wiring 122A via a contact 123A. The lower electrode 142 is connected with a wiring 122B.

The upper electrode 141 is formed with a single layer film for which a material such as titanium nitride (TiN), tantalum (Ta), tantalum nitride (TaN), or tungsten nitride (WN) is used, or a laminated film formed by laminating these materials. The lower electrode 142 is formed with a single layer film or a laminated film for which a material such as titanium nitride (TiN) is used similarly to the upper electrode 141. The dielectric 143 is formed with a single layer film for which a high permittivity material such as aluminum oxide (AlO), hafnium oxide (HfO), zirconium oxide (ZrO), or niobium oxide (NbO) is used, or a laminated film obtained by laminating these materials. The cap film 144 is formed with a film for which a material such as silicon nitride (SiN), silicon oxide (SiO), or silicon carbonitride (SiCN) is used.

The MIM capacitive element 132 has a similar structure to that of the MIM capacitive element 131 illustrated in Fig. 3, yet has a different film type, thickness, and area of the dielectric 143. As for the film type of the dielectric 143, the film type may be varied not only by changing the above material or but also by using a film having different characteristics even in a case of the same material. The thickness of the dielectric 143 is indicated in the Z direction, and is represented by h in Fig. 3. The area of the dielectric 143 is an area of the plane in the X and Y directions. Such a difference between the structures makes the capacitances of the MIM capacitive element 131 and the MIM capacitive element 132 different. For example, it is desirable to make the capacitance of the MIM capacitive element 132 larger than the capacitance of the MIM capacitive element 131, and make a capacitance ratio of these capacitances approximately 1:30.

As described above, although the MIM capacitive element 131 and the MIM capacitive element 132 have the structures whose at least ones of the film types, the thicknesses, and the areas of the dielectrics 143 are different, yet the other structures may be different. For example, the MIM capacitive element 131 and the MIM capacitive element 132 may have different heights that are represented by H in Fig. 3. Furthermore, the structures of the MIM capacitive element 131 and the MIM capacitive element 132, and a manufacturing process thereof may be different. The MIM capacitive element 131 and the MIM capacitive element 132 have the three-dimensional structures, so that it is possible to increase the capacitance per unit area, and achieve miniaturization.

Fig. 4 is a diagram illustrating a first example of a circuit configuration of the pixel 100. In Fig. 4, the pixel 100 includes the photodiode 111, the MIM capacitive element 131, the MIM capacitive element 132, a transfer transistor 161, an FD 162, a switch transistor 163, a reset transistor 164, an amplifier transistor 165, a selection transistor 166, a first storage transistor 167, and a second storage transistor 168.

The transfer transistor 161 is provided between the photodiode 111 and the FD 162, and transfers the charge stored in the photodiode 111 to the FD 162 according to a drive signal TGL to be applied to a gate voltage of the transfer transistor 161. The FD 162 is a Floating Diffusion (FD) that converts the charge from the photodiode 111 into a voltage signal.

The FD 162 is connected with the switch transistor 163 for switching conversion efficiency, and is connected with the reset transistor 164 via the switch transistor 163. Furthermore, the FD 162 is also connected with the vertical signal line 42 via the amplifier transistor 165 and the selection transistor 166. The first storage transistor 167 is connected between the switch transistor 163 and the reset transistor 164. The first storage transistor 167 is connected with the MIM capacitive element 131 and the second storage transistor 168. The second storage transistor 168 is connected with the MIM capacitive element 132. An upper electrode of the MIM capacitive element 131 and an upper electrode of the MIM capacitive element 132 are connected with a common control power supply (VMID).

The switch transistor 163 switches a connection state between the FD 162, and the reset transistor 164 and the first storage transistor 167 according to a drive signal FDG to be applied to a gate voltage of the switch transistor 163. The first storage transistor 167 switches a connection state with the MIM capacitive element 131 according to a drive signal FCG1 to be applied to a gate electrode of the first storage transistor 167. The second storage transistor 168 switches a connection state with the MIM capacitive element 132 according to a drive signal FCG2 to be applied to a gate electrode of the second storage transistor 168.

In, for example, a storage period, a charge before the photodiode 111 is saturated is stored in the photodiode 111, and a charge at a time when the photodiode 111 is over-saturated can be stored in the MIM capacitive element 131 via the transfer transistor 161, the switch transistor 163, and the first storage transistor 167. Furthermore, the charge at a time when the photodiode 111 and the MIM capacitive element 131 are over-saturated can be stored in the MIM capacitive element 132 via the second storage transistor 168.

The reset transistor 164 drains and resets the charges of the FD 162, the MIM capacitive element 131, and the MIM capacitive element 132 according to a drive signal RST to be applied to a gate electrode of the reset transistor 164. The amplifier transistor 165 is an input unit of a source follower circuit that has a gate electrode connected to the FD 162 and a drain connected to a power supply voltage (VDD), and reads out the charge obtained by photoelectric conversion by the photodiode 111. That is, the amplifier transistor 165 includes the source connected to the vertical signal line 42 via the selection transistor 166 to constitute a constant current source and the source follower circuit connected to one end of the vertical signal line 42.

The selection transistor 166 is connected between the source of the amplifier transistor 165 and the vertical signal line 42. The selection transistor 166 brings the pixel 100 in a selected state according to a drive signal SEL to be applied to a gate electrode of the selection transistor 166. When the pixel 100 is brought into the selected state, a signal output from the amplifier transistor 165 is read out by the column signal processing unit 23 via the vertical signal line 42.

Fig. 5 is a plan view illustrating a first example of the configuration of the pixel 100. Parts corresponding to those in the circuit diagram in Fig. 4 will be assigned the same reference numerals in the plan view of Fig. 5. In Figs. 4 and 5, the charges having overflown from the photodiode 111 are stored in the MIM capacitive element 131 and the MIM capacitive element 132 via the transfer transistor 161 that is a transfer gate. That is, the configurations illustrated in Figs. 4 and 5 are Transfer Gate (TG) type configurations. Furthermore, the configurations illustrated in Figs. 4 and 5 are configurations where the FD 162 connected with the MIM capacitive element 131 and the MIM capacitive element 132 are isolated by the operation of the second storage transistor 168 to read out the charges respectively stored in the MIM capacitive element 131 and the MIM capacitive element 132.

Next, an example of a read-out operation of the pixel 100 will be described with reference to a timing chart in Fig. 6. In Fig. 6, VMID represents a common control signal of the MIM capacitive elements 131 and 132 in the circuit diagram in Fig. 4. SEL, FDG, TGL, RST, FCG1, and FCG2 represent drive signals to be applied to the gate electrode of each transistor in the circuit diagram in Fig. 4. The drive signal is applied by the vertical drive unit 22 under control of the control unit 26. Each transistor enters an on state when the drive signal reaches an H level, and enters an off state when the drive signal reaches an L level.

In Fig. 6, a storage period starts after a shutter (SHT) is released at a time t0. When the control signal VMID and the drive signals FDG, TGL, RST, FCG1, and FCG2 reach the H level before the storage period, the FD 162 and the MIM capacitive elements 131 and 132 are reset. When the drive signal FDG reaches the H level at a time t1 after the storage period, and then the drive signal SEL reaches the H level, a reset level of low conversion efficiency of the photodiode 111 can be obtained (P-PD_L). Then, when the drive signal FDG reaches the L level at a time t2 in a state where the drive signal SEL continues the H level, the reset level of high conversion efficiency of the photodiode 111 can be obtained (P-PD_H).

Next, when the drive signal SEL reaches the L level and the drive signal TGL reaches the H level at a time t3, a signal level of high conversion efficiency of the photodiode 111 can be obtained (D-PD_H). Furthermore, when the drive signal FDG reaches the H level immediately before a time t4, and the drive signal SEL reaches the L level and the drive signal TGL reaches the H level at the time t4, the signal level of low conversion efficiency can be obtained (D-PD_L). Note that the drive signal FDG maintains the H level thereafter.

The signal level and the reset level obtained as described above are output from the pixel 100, so that, by performing Correlated Double Sampling (CDS) based on these signal level and reset level, the column signal processing unit 23 can read out a signal obtained from the charge stored in the photodiode 111 (PD Read (CDS)).

Subsequently, when the drive signal FCG1 reaches the H level at a time t5, the signal level of the MIM capacitive element 131 can be obtained (D-MIM1). The drive signal FCG1 maintains the H level at or after the time t5. Next, when the drive signal SEL reaches the L level and the drive signal FCG2 reaches the H level at a time t6, a signal level of the MIM capacitive element 132 can be obtained (D-MIM2). The drive signal FCG2 maintains the H level between the time t6 and a time t8. Next, when the drive signal RST reaches the H level at the time t7, the reset level of the MIM capacitive element 132 can be obtained (P-MIM2). When the drive signal SEL reaches the L level and the drive signal FCG2 reaches the L level at the time t8, a reset level of the MIM capacitive element 131 can be obtained (P-MIM1).

The signal level and the reset level obtained as described above are output from the pixel 100, so that, by performing Double Data Sampling (DDS) based on these signal level and reset level, the column signal processing unit 23 can read out signals obtained from the charges respectively stored in the MIM capacitive element 131 and the MIM capacitive element 132 (PD+MIM1+MIM2 Read(DDS)). That is, it is possible to individually read out the charges respectively stored in the photodiode 111, the MIM capacitive element 131, and the MIM capacitive element 132.

Although the above-described configuration has been described as the TG type configuration, other configurations may be adopted. For example, it is possible to adopt an Over Flow Gate (OFG) type configuration where an overflow path from the photodiode 111 is another path different from that of the transfer gate. Fig. 7 illustrates the OFG type configuration as a second example of the circuit configuration of the pixel 100. Furthermore, Fig. 8 is a plan view corresponding to the circuit configuration in Fig. 7.

In Fig. 7, the photodiode 111 is connected with the transfer transistor 161, and is connected with a connection transistor 181 that is an overflow gate. The connection transistor 181 is connected to a connection point of the first storage transistor 167, the second storage transistor 168, and the MIM capacitive element 131. The connection transistor 181 switches a connection state between the photodiode 111 and the MIM capacitive element 131 according to a drive signal OFG to be applied to a gate electrode of the connection transistor 181.

Consequently, the charge before the photodiode 111 is saturated is stored in the photodiode 111, and the charge at a time when the photodiode 111 is over-saturated is stored in the MIM capacitive element 131 via the connection transistor 181. Furthermore, the charge at a time when the photodiode 111 and the MIM capacitive element 131 are over-saturated can be stored in the MIM capacitive element 132 via the connection transistor 181 and the second storage transistor 168.

Both of the TG type configuration and the OFG type configuration are configurations where the floating diffusions connected with the MIM capacitive element 131 and the MIM capacitive element 132 are isolated by the second storage transistor 168, and charges stored in the respective floating diffusions are read out. The TG type configuration can be configured by reducing the number of transistors compared to the OFG type configuration. According to the OFG type configuration, a region of the floating diffusion at a time when the charges stored in the MIM capacitive element 131 and the MIM capacitive element 132 are read out, and is separated from a region of the floating diffusion at a time when the charge stored in the photodiode 111 is read out, so that it is possible to reduce noise at the former time of reading out of the charges.

As described above, the solid-state imaging device 10 has the multistage structure (two-stage structure) that the MIM capacitive element 131 and the MIM capacitive element 132 having the different capacitances are disposed per pixel 100, and charges having overflown from the photodiode 111 are stored in the MIM capacitive element 131 and the MIM capacitive element 132, and signals obtained from the charges stored in the photodiode 111, the MIM capacitive element 131, and the MIM capacitive element 132 are individually read out. Note that a read-out method only needs to individually read out signals obtained from the charges stored in the photodiode 111, the MIM capacitive element 131, and the MIM capacitive element 132, and is not limited to the operation illustrated in Fig. 6, and other read-out methods may be used.

By the way, although, according to above-described PTL 1, a storage capacitance that stores charges having overflown from a photodiode is disposed as a one-stage structure, increasing an intra-pixel capacitance to expand a dynamic range lowers conversion efficiency in a case of the one-stage structure, and therefore random noise deteriorates in proportion to a root of the capacitance.

That is, conversion efficiency (η) of a pixel is determined according to η[V/e-] = q[C]/C_{fd}[F] in proportion to an FD capacitance and becomes smaller as the capacitance becomes larger. On the other hand, a random noise component is read out by DDS in a case of the one-stage structure, and therefore circuit noise, kTC noise, and AMP noise become dominant. Here, in a case where the circuit noise is σ_{AFE}, the kTC noise is σ_{KTC}, and the AMP noise is σ_{AMP}, total random noise σₜₒₜₐₗ is a square sum of each noise. To convert the noise component into the number of electrons, the noise component is divided by conversion efficiency, and therefore σₜₒₜₐₗ/η[e-rms] holds. σ_{KTC} is inversely proportional to √2kT/C and the capacitance, and deteriorates depending on the root of the capacitance when converted into the number of electrons. Therefore, it is necessary to limit the intra-pixel capacitance to make an SN ratio a certain reference or more, and it is difficult to balance between the intra-pixel capacitance and the dynamic range.

Furthermore, although, according to above-described PTL 2, storage capacitances that store charges having overflown from a photodiode are disposed as a two-stage structure to achieve a wider dynamic range while keeping SN ratios, a wiring capacitive element (MIM capacitive element) is not disposed as the storage capacitance in this structure. Hence, two storage capacitances are disposed on the same plane as that of the photodiode, and therefore the area of the photodiode (an area of a plane on a light incidence surface side) is limited. Furthermore, the photodiode and the two storage capacitances are disposed on the same plane, and therefore are not suitable for miniaturization of pixels, either.

By contrast with this, the solid-state imaging device 10 to which the present disclosure is applied has the structure that the MIM capacitive element of the two stages are disposed as storage capacitances that store charges having overflown from the photodiode 111, so that, by sequentially reading out signals obtained from the charges stored in the photodiode 111, the MIM capacitive element 131, and the MIM capacitive element 132, it is possible to suppress the conversion efficiency ratio to a degree (approximately 1:30) matching the capacitance ratio, and expand the dynamic range without deteriorating the SN ratios of the MIM capacitive elements.

Furthermore, the MIM capacitive element 131 and the MIM capacitive element 132 are wiring capacitive elements, and are disposed between wiring layers, so that the MIM capacitive element 131 and the MIM capacitive element 132 are not disposed on the same plane as that of the photodiode 111, and do not limit the area of the photodiode 111 (the area of the plane on the light incidence surface side). Furthermore, the photodiode 111, the MIM capacitive element 131, and the MIM capacitive element 132 are not disposed on the same plane, so that there is also an advantage for miniaturization of pixels. Although, particularly in a case where the capacitance ratio of the storage capacitances of the two-stage structure is approximately 1:30, it is difficult to dispose the photodiode and the two storage capacitances on the same plane depending on pixel sizes, disposing the MIM capacitive element 131 and the MIM capacitive element 132 having the different capacitances between the wiring layers is advantageous for miniaturization.

As described above, in the solid-state imaging device 10 to which the present disclosure is applied, the pixel 100 has the first structure (Fig. 2 and the other figures), so that the photodiode 111 and the MIM capacitive elements 131 and 132 are not disposed on the same plane, and it is possible to achieve both of suppression of deterioration of the SN ratio and expansion of the dynamic range. That is, it is possible to achieve desired characteristics with a more appropriate layout.

### <Second Configuration>

Although the first configuration (Fig. 2 and the other figures) has been described as a configuration where the MIM capacitive element 131 and the MIM capacitive element 132 are disposed between different wiring layers in the wiring layer 12, there may be employed a configuration where the MIM capacitive element 131 and the MIM capacitive element 132 are disposed between the same wiring layers. Fig. 9 is a cross-sectional view illustrating a second example of a structure of a pixel. In Fig. 9, in the wiring layer 12, the MIM capacitive element 131 and the MIM capacitive element 132 are disposed at the same position in the Z direction, and are disposed between the same wiring layers. That is, in the wiring layer 12, both of the MIM capacitive element 131 and the MIM capacitive element 132 are disposed between the first wiring layers.

In Fig. 9, the MIM capacitive element 131 and the MIM capacitive element 132 have the structures illustrated in Fig. 3, have the different film types, thicknesses, and the like of the dielectrics 143, and therefore have the different capacitances. In Fig. 9, too, the capacitance ratio of the capacitance of the MIM capacitive element 131 and the capacitance of the MIM capacitive element 132 is a desired capacitance ratio.

The second configuration can adopt the TG type or OFG type configuration as a circuit configuration thereof similarly to the above-described first configuration. Furthermore, a configuration and an operation of a read-out unit that individually reads out charges respectively stored in the photodiode 111, the MIM capacitive element 131, and the MIM capacitive element 132 in the second configuration are the same as those of the above-described first configuration. Description of these configuration and operation is repetition, and therefore will be omitted.

### <Third Configuration>

Although the inter-pixel isolation part 112 is formed as the trench formed from the surface on the side opposite to the light incidence surface in the first configuration (Fig. 2 and the other figures) and the second configuration (Fig. 9), there may be employed a configuration where the inter-pixel isolation part 112 is formed as a trench formed from the light incidence surface side. Fig. 10 is a cross-sectional view illustrating a third example of a structure of a pixel. In Fig. 10, the inter-pixel isolation part 113 is formed by burying a metal film, an insulating film, or the like in a trench formed at a predetermined depth from the light incidence surface side in a semiconductor substrate.

In Fig. 10, in the wiring layer 12, the MIM capacitive element 131 and the MIM capacitive element 132 are disposed between the different wiring layers, yet may be disposed between the same wiring layers. The MIM capacitive element 131 and the MIM capacitive element 132 have different capacitances to achieve a desired capacitance ratio.

The third configuration can adopt the TG type or OFG type configuration as a circuit configuration thereof similarly to the above-described first configuration. Furthermore, a configuration and an operation of a read-out unit that individually reads out charges respectively stored in the photodiode 111, the MIM capacitive element 131, and the MIM capacitive element 132 in the third configuration are also the same as those of the above-described first configuration. Description of these configuration and operation is repetition, and therefore will be omitted.

### <Fourth Configuration>

Although the first configuration (Fig. 4) is the TG type circuit configuration where the common control power supply (VMID) is connected to the upper electrode of the MIM capacitive element 131 and the upper electrode of the MIM capacitive element 132 to make a control signal (VMID signal) common, the MIM capacitive element 131 and the MIM capacitive element 132 may be individually controlled. Fig. 11 is a diagram illustrating another example of the TG type circuit configuration illustrated in Fig. 4. In Fig. 11, the upper electrode of the MIM capacitive element 131 is connected to a control power supply VMID1, and the upper electrode of the MIM capacitive element 132 is connected to a control power supply VMID2.

The circuit configuration in Fig. 11 can independently control the control signal VMID1 of the MIM capacitive element 131 and the control signal VMID2 of the MIM capacitive element 132, and individually adjust charge amounts (electron amounts) respectively stored in the MIM capacitive element 131 and the MIM capacitive element 132. Furthermore, when the voltage of the control signal VMID is increased in the storage period, saturation charges of the MIM capacitive elements increase, a dark current deteriorates, and therefore the SN ratio and the dynamic range are trade-off. Hence, in the circuit configuration in Fig. 11, by independently controlling the MIM capacitive element 131 and the MIM capacitive element 132 using the control signal VMID1 and the control signal VMID2, and enabling optimal voltage control. This makes it easy to achieve both the SN ratios of the MIM capacitive elements and the dynamic range.

Fig. 12 is a timing chart for describing an example of a read-out operation of the circuit configuration in Fig. 11. Compared to the timing chart in Fig. 6, in the timing chart in Fig. 12, the common control signal VMID for the MIM capacitive elements 131 and 132 are changed to the control signal VMID1 for the MIM capacitive element 131, and the control signal VMID2 for the MIM capacitive element 132. Consequently, the MIM capacitive element 131 and the MIM capacitive element 132 are individually controlled. Since a timing of a drive signal such as SEL in Fig. 12 is similar to that in Fig. 6, description thereof will be omitted.

Note that, although Fig. 11 illustrates the example of the TG type circuit configuration, the OFG type circuit configuration can also adopt the same configuration. Fig. 13 is a diagram illustrating another example of the OFG type circuit configuration illustrated in Fig. 7. Similarly to Fig. 11, in Fig. 13, the upper electrode of the MIM capacitive element 131 is connected to the control power supply VMID 1, and the upper electrode of the MIM capacitive element 132 is connected to the control power supply VMID2, so that it is possible to individually control the MIM capacitive element 131 and the MIM capacitive element 132.

### <Fifth Configuration>

Fig. 14 is a cross-sectional view illustrating another example of the structure of the pixel 100. The cross-sectional view of Fig. 14 corresponds to an X-X' cross section in a plan view of Fig. 15.

Each pixel 100 is formed by laminating the semiconductor layer 11 and the wiring layer 12. In the semiconductor layer 11, a photodiode 211-1 and a photodiode 211-2 are formed per pixel 100. As illustrated in the plan view of Fig. 15, an L-shaped region is a region of the photodiode 211-1, and the rest of a rectangular region is a region of the photodiode 211-2 in a region of the plane in the X and Y directions (the plane on the light incidence surface side). As described above, the photodiode 211-1 has a larger area of a light reception surface than that of the photodiode 211-2, and has high sensitivity with respect to light. That is, the pixel 100 is provided with two photodiodes having different sensitivities.

Light incidence surface sides of the photodiode 211-1 and the photodiode 211-2 are provided with a color filter 201 and an on-chip microlens 202. As illustrated in the plan view of Fig. 15, three on-chip microlenses 202-1-1 to 202-1-3 are provided to meet the L-shaped region of the photodiode 211-1, and one on-chip microlens 202-2 is provided to meet the rectangular region of the photodiode 211-2. The shapes and the number of the on-chip microlenses 202 disposed per pixel 100 are arbitrary, and, for example, the diameters of the on-chip microlenses 202-1-1 and 202-1-3 may be made larger than the diameters of the on-chip microlenses 202-1-2 and 202-2.

The color filter 201 is configured as, for example, a filter that allows transmission of a wavelength of the same color per pixel 100. Each pixel 100 is isolated by the inter-pixel isolation part 212. Furthermore, in each pixel 100, the photodiode 211-1 and the photodiode 211-2 are also isolated by the inter-pixel isolation part 212.

The wiring layer 12 is a multilayer wiring layer that includes a plurality of wiring layers obtained by being stacked at a plurality of stages and forming a wiring 222 in each stage with an inter-wiring film 221 interposed therebetween. In the wiring layer 12, an MIM capacitive element 231 and an MIM capacitive element 232 are disposed as wiring capacitive elements having different capacitances. The MIM capacitive element 231 and the MIM capacitive element 232 are provided per pixel 100. The MIM capacitive element 231 and the MIM capacitive element 232 are disposed between different wiring layers. The MIM capacitive element 231 and the MIM capacitive element 232 can have the three-dimensional structures similar to the structure illustrated in Fig. 3. That is, the MIM capacitive element 231 and the MIM capacitive element 232 can have the structures whose at least ones of the film types, the thicknesses, and the areas of the dielectrics are different. For example, the capacitance of the MIM capacitive element 232 is larger than the capacitance of the MIM capacitive element 231.

The MIM capacitive element 231 stores a charge having overflown from the photodiode 211-1. The MIM capacitive element 232 stores a charge having overflown from the photodiode 211-2. This structure makes it possible to store in the MIM capacitive element 231 and the MIM capacitive element 232 the charges having overflown from the photodiodes 211-1 and 211-2 together with the charges stored in the photodiodes 211-1 and 212-2, and read out the charges.

Fig. 16 is a diagram illustrating an example of the circuit configuration of the pixel 100 in Fig. 14. In Fig. 16, the pixel 100 includes the photodiodes 211-1 and 211-2, the MIM capacitive elements 231 and 232, a transfer transistor 261, an FD 262, a switch transistor 263, a reset transistor 264, an amplifier transistor 265, a selection transistor 266, a switch transistor 267, a storage transistor 268, and an FD 269.

The transfer transistor 261 is provided between the photodiode 211-1 and the FD 262, and transfers the charge stored in the photodiode 211-1 to the FD 262 according to the drive signal TGL to be applied to a gate voltage of the transfer transistor 261. The FD 262 is a floating diffusion that converts the charge from the photodiode 211-1 into a voltage signal. The FD 262 is connected with the vertical signal line 42 via the amplifier transistor 265 and the selection transistor 266.

The FD 262 is connected with the switch transistor 263 for switching conversion efficiency, and is connected with the switch transistor 267 and the storage transistor 268 via the switch transistor 263. The switch transistor 267 is connected with the MIM capacitive element 231 and the reset transistor 264. A region including a connection point of the photodiode 211-2, the MIM capacitive element 232, and the storage transistor 268 is the FD 269. The FD 269 is a floating diffusion that converts the charge from the photodiode 211-2 into a voltage signal. An upper electrode of the MIM capacitive element 231 and an upper electrode of the MIM capacitive element 232 are connected with a control power supply (VMID).

The switch transistor 263 switches a connection state between the FD 262, the switch transistor 267, and the storage transistor 268 according to the drive signal FDG to be applied to a gate voltage of the switch transistor 263. The switch transistor 267 switches a connection state between the switch transistor 263, the MIM capacitive element 231, and the reset transistor 264 according to the drive signal LCG to be applied to a gate voltage of the switch transistor 267. The storage transistor 268 switches a connection state between the switch transistor 263 and the FD 269 according to the drive signal FCG to be applied to a gate electrode of the storage transistor 268.

In, for example, a storage period, a charge before the photodiode 211-1 is saturated is stored in the photodiode 211-1, and a charge at a time when the photodiode 211-1 is over-saturated can be stored in the MIM capacitive element 231 via the transfer transistor 261, the switch transistor 263, and the switch transistor 267. Furthermore, the charge of the photodiode 211-2 can be stored in the MIM capacitive element 232.

Next, an example of the read-out operation of the pixel 100 in Fig. 16 will be described with reference to a timing chart in Fig. 17. In Fig. 17, VMID represents a common control signal of the MIM capacitive elements 231 and 232 in the circuit diagram in Fig. 16. SEL, FDG, TGL, RST, LCG, and FCG represent drive signals to be applied to the gate electrode of each transistor in the circuit diagram in Fig. 16.

In Fig. 17, a storage period starts after a shutter (SHT) is released at the time t0. When the control signal VMID and the drive signals FDG, TGL, RST, LCG, and FCG reach the H level before the storage period, the FDs 262 and 269 and the MIM capacitive elements 231 and 232 are reset. When the drive signal FDG reaches the H level at the time t1 after the storage period, and then the drive signal SEL reaches the H level, a reset level of intermediate conversion efficiency of the photodiode 211-1 can be obtained (P-SP1_M). Then, when the drive signal FDG reaches the L level at the time t2 in a state where the drive signal SEL continues the H level, the reset level of high conversion efficiency of the photodiode 211-1 can be obtained (P-SP1_H).

Next, when the drive signal SEL reaches the L level and the drive signal TGL reaches the H level at the time t3, a signal level of high conversion efficiency of the photodiode 211-1 can be obtained (D-SP1_H). Furthermore, when the drive signal FDG reaches the H level immediately before the time t4, and the drive signal SEL reaches the L level and the drive signal TGL reaches the H level at the time t4, the signal level of intermediate conversion efficiency can be obtained (D-SP1_M). Note that the drive signal FDG maintains the H level thereafter.

The signal level and the reset level obtained as described above are output from the pixel 100, so that, by performing CDS based on these signal level and reset level, it is possible to read out a signal obtained from the charge stored in the photodiode 211-1 (PD Read (CDS)).

Subsequently, when the drive signal LCG reaches the H level immediately before the time t5, a signal level of low conversion efficiency of the photodiode 211-1 can be obtained (D-SP1_L). The drive signal LCG maintains the H level up to a time immediately before the time t7. Next, when the drive signal SEL reaches the L level and the drive signal RST reaches the H level at the time t6, a reset level of low conversion efficiency of the photodiode 211-1 can be obtained (P-SP1_L). The signal level and the reset level obtained as described above are output from the pixel 100, so that, by performing DDS based on these signal level and reset level, it is possible to read out the charge stored in the MIM capacitive element 231 together with the charge stored in the photodiode 211-1 (PD+MIM1 Read(DDS)).

Subsequently, when the drive signal FCG reaches the H level at the time t7, a signal level of the photodiode 211-2 can be obtained (D-SP2). The drive signal FCG maintains the H level thereafter. Next, when the drive signal SEL reaches the L level and the drive signal RST reaches the H level at the time t8, a reset level of the photodiode 211-2 can be obtained (P-SP2). The signal level and the reset level obtained as described above are output from the pixel 100, so that, by performing DDS based on these signal level and reset level, it is possible to read out the charge stored in the MIM capacitive element 232 together with the charge stored in the photodiode 211-2 (PD+MIM2 Read(DDS)). As described above, it is possible to individually read out the charges respectively stored in the photodiode 211-1, the photodiode 211-2, the MIM capacitive element 231, and the MIM capacitive element 232.

Note that, although the cross-sectional view of Fig. 14 illustrates the case where the MIM capacitive element 231 and the MIM capacitive element 232 are disposed between the different wiring layers, the MIM capacitive element 231 and the MIM capacitive element 232 may be disposed between the same wiring layers. Furthermore, although the inter-pixel isolation part 212 is formed as the trench formed penetrating the surface on the side opposite to the light incidence surface in the cross-sectional view of Fig. 14, there may be employed a configuration where the inter-pixel isolation part 212 is formed as a trench formed at a predetermined depth from the light incidence surface side.

As described above, the solid-state imaging device 10 has the structure (so-called multistage structure) that the photodiode 211-1 and the photodiode 211-2 having the different sensitivities, and the MIM capacitive element 231 and the MIM capacitive element 232 having the different capacitances are disposed per pixel 100, and charges having overflown from the photodiode 211-1 are stored in the MIM capacitive element 231 and charges having overflown from the photodiode 211-2 are stored in the MIM capacitive element 232, and individually read out the charges stored in the photodiode 211-1, the photodiode 211-2, the MIM capacitive element 231, and the MIM capacitive element 232.

Here, the MIM capacitive element 231 is connected to the FD 262 of the photodiode 211-1, and the MIM capacitive element 232 is connected to the FD 269 of the photodiode 211-2. Note that a read-out method only needs to individually read out signals obtained from the charges stored in the photodiode 211-1, the photodiode 211-2, the MIM capacitive element 231, and the MIM capacitive element 232, and is not limited to the operation illustrated in Fig. 17, and other read-out methods may be used.

As described above, in the solid-state imaging device 10 to which the present disclosure is applied, the pixel 100 has the fifth structure (Fig. 14 and the other figures), so that the photodiodes 211-1 and 211-2, and the MIM capacitive elements 231 and 232 are not disposed on the same plane, and it is possible to expand the dynamic range depending on a sensitivity ratio of the photodiodes 211-1 and 211-2 having the different sensitivities and the MIM capacitive elements 231 and 232 having the different capacitances. That is, it is possible to achieve desired characteristics with a more appropriate layout.

### <Modification>

### <Other Structure of MIM Capacitive Element>

Although the three-dimensional structure has been described as the structures of the MIM capacitive element 131 and the MIM capacitive element 132 in the above description, other structures may be adopted. Fig. 18 is a cross-sectional view illustrating another example of the structure of the MIM capacitive element 131. In Fig. 18, the MIM capacitive element 131 has a two-dimensional structure in the X and Y directions.

The MIM capacitive element 131 has the structure formed by laminating an upper electrode 151 formed with a single layer film or a laminated film for which a material such as titanium nitride (TiN) is used, a lower electrode 152 formed with a single layer film or a laminated film for which a material such as titanium nitride (TiN) is used, and a dielectric 153 sandwiched between the upper electrode 151 and the lower electrode 152. The dielectric 153 is formed with a single layer film or a laminated film of a high dielectric material such as aluminum oxide (AlO). A cap film 154 formed with a film such as silicon nitride (SiN) is formed on the upper surface of the upper electrode 151. The upper electrode 151 is connected with a wiring 122C via a contact 123B. The lower electrode 152 is connected with a wiring 122D.

The MIM capacitive element 132 can have the structure similar to that of the MIM capacitive element 131 illustrated in Fig. 18. At least ones of the film types, the thicknesses, and the areas of the dielectrics 153 are different, so that the MIM capacitive element 131 and the MIM capacitive element 132 have the different capacitances. The thickness of the dielectric 153 is represented by h in Fig. 18. The area of the dielectric 153 is an area of the plane in the X and Y directions. The MIM capacitive element 231 and the MIM capacitive element 232 in the fifth configuration (Fig. 14 and the other figures) are not limited to the three-dimensional structures, either, and may also have the two-dimensional structures illustrated in Fig. 18. Note that the number of MIM capacitive elements disposed per pixel 100 is not limited to two, and may be three or more. Furthermore, the number of the photodiodes 211 formed per pixel 100 is not limited to two and may be three or more in the fifth configuration, and the MIM capacitive elements may be disposed according to the number of the photodiodes 211.

### <Example of Light Detection Device>

The solid-state imaging device 10 has been described as a CMOS type solid-state imaging device in the above description, and the CMOS type solid-state imaging device can have a back-illuminated structure in which light is incident from the upper layer (back surface side) located on the side opposite to the wiring layer side (front surface side) formed in the lower layer when viewed from the semiconductor substrate in which the photodiode 111 is formed as the photoelectric conversion unit. Note that the CMOS type solid-state imaging device may have a front-illuminated structure in which the side on which light is incident is the wiring layer side (front surface side).

The solid-state imaging device 10 is an example of the light detection device to which the present disclosure is applied. That is, the light detection device to which the present disclosure is applied is not limited to the solid-state imaging device 10, and is applicable to, for example, a device that detects light such as a distance measurement sensor that uses an IR laser. Note that the configuration to which the present disclosure is applied is not limited to the CMOS type solid-state imaging device, and is also applicable to other solid-state imaging devices such as the Charge Coupled Device (CCD) type.

### <Configuration of Electronic Device>

The solid-state imaging device to which the present disclosure is applied can be installed in an electronic device such as a smartphone, a tablet terminal, a mobile phone, a digital still camera, and a digital video camera. Fig. 19 is a block diagram illustrating a configuration example of an electronic device including the built-in solid-state imaging device to which the present disclosure is applied.

In Fig. 19, an electronic device 1000 includes an imaging system including an optical system 1011 including a lens group, a solid-state imaging device 1012 having a function corresponding to the solid-state imaging device 10 in Fig. 1, and a Digital Signal Processor (DSP) 1013 that is a camera signal processing unit. In the electronic device 1000, in addition to the imaging system, a Central Processing Unit (CPU) 1010, a frame memory 1014, a display 1015, an operation system 1016, an auxiliary memory 1017, a communication I/F 1018, and a power supply system 1019 are connected to each another via a bus 1020.

The CPU 1010 controls an operation of each unit of the electronic device 1000. The optical system 1011 captures incident light (image light) from a subject and forms an image on a light detection surface of the solid-state imaging device 1012. The solid-state imaging device 1012 converts the light amount of incident light, with which an image is formed on the light detection surface by the optical system 1011, into an electrical signal in units of pixels, and outputs the electrical signal as a signal. The DSP 1013 performs predetermined signal processing on the signal output from the solid-state imaging device 1012.

The frame memory 1014 temporarily records image data of a still image or a video captured by the imaging system. The display 1015 is a liquid crystal display or an organic EL display, and displays a still image or a video captured by the imaging system. The operation system 1016 issues an operation command for various functions of the electronic device 1000 in response to a user operation.

The auxiliary memory 1017 is a storage medium including a semiconductor memory such as a flash memory, and records image data of a still image or a video captured by the imaging system. The communication I/F 1018 has a communication module that supports a predetermined communication method, and transmits image data of a still image or a video captured by the imaging system to other devices via a network.

The power supply system 1019 appropriately supplies various power supplies functioning as the operating power supply to the CPU 1010, the DSP 1013, the frame memory 1014, the display 1015, the operation system 1016, the auxiliary memory 1017, and the communication I/F 1018 as supply targets.

Note that the embodiments of the present disclosure are not limited to the above-described embodiments, and various modifications can be made without departing from the essential spirit of the present disclosure. Furthermore, the effects described in this description are merely illustrative and not limiting, and other effects may be obtained.

The present disclosure can also be configured as follows.

(1) A solid-state imaging device includes:
   a plurality of pixels that each include a photoelectric conversion element and a plurality of wiring capacitive elements; and
   a read-out unit that reads out signals from the plurality of pixels,
   the solid-state imaging device has a structure that a charge having overflown from the photoelectric conversion element is stored in a first wiring capacitive element, and the charge having overflown from the first wiring capacitive element is stored in a second wiring capacitive element, and the read-out unit individually reads out a signal of each of the photoelectric conversion element, the first wiring capacitive element, and the second wiring capacitive element.
(2) The solid-state imaging device described in above (1), in which the first wiring capacitive element and the second wiring capacitive element are disposed between different wiring layers.
(3) The solid-state imaging device described in above (1), in which the first wiring capacitive element and the second wiring capacitive element are a first MIM capacitive element and a second MIM capacitive element having different capacitances.
(4) The solid-state imaging device described in above (3), in which the first MIM capacitive element and the second MIM capacitive element have structures whose at least ones of film types, thicknesses, and areas of dielectrics are different.
(5) The solid-state imaging device described in above (3) or (4), in which the first MIM capacitive element and the second MIM capacitive element have three-dimensional structures.
(6) The solid-state imaging device described in any one of (1) to (4), in which the solid-state imaging element has a structure that the charge having overflown from the photoelectric conversion element overflows to the first wiring capacitive element from an overflow path different from a path of a transfer gate that transfers the charge stored in the photoelectric conversion element.
(7) A solid-state imaging device includes:
   a plurality of pixels that each include a plurality of photoelectric conversion elements and a plurality of wiring capacitive elements; and
   a read-out unit that reads out signals from the plurality of pixels,
   the solid-state imaging device has a structure that a first wiring capacitive element and a second wiring capacitive element are respectively connected to floating diffusions of a first photoelectric conversion element and a second photoelectric conversion element, and a charge having overflown from the first photoelectric conversion element is stored in the first wiring capacitive element, and the charge having overflown from the second photoelectric conversion element is stored in the second wiring capacitive element, and the read-out unit individually reads out a signal of each of the first photoelectric conversion element, the second photoelectric conversion element, the first wiring capacitive element, and the second wiring capacitive element.
(8) The solid-state imaging device described in above (7), in which the first wiring capacitive element and the second wiring capacitive element are disposed between different wiring layers.
(9) The solid-state imaging device described in above (7), in which the first wiring capacitive element and the second wiring capacitive element are a first MIM capacitive element and a second MIM capacitive element having different capacitances.
(10) The solid-state imaging device described in above (9), in which the first MIM capacitive element and the second MIM capacitive element have structures whose at least ones of film types, thicknesses, and areas of dielectrics are different.
(11) The solid-state imaging device described in above (9) or (10), in which the first MIM capacitive element and the second MIM capacitive element have three-dimensional structures.
(12) The solid-state imaging device described in any one of (7) to (10), in which the first photoelectric conversion element and the second photoelectric conversion element have different sensitivities.

### [Reference Signs List]

10 Solid-state imaging device
21 Pixel array unit
22 Vertical drive unit
23 Column signal processing circuit
24 Horizontal drive unit
25 Output unit
26 Control unit
42 Vertical signal line
100 Pixel
101 Color filter
102 On-chip microlens
111 Photodiode
112, 113 Inter-pixel isolation part
121 Inter-wiring layer film
122 Wiring
131 MIM capacitive element
132 MIM capacitive element
141 Upper electrode
142 Lower electrode
143 Dielectric
144 Cap film
161 Transfer transistor
162 FD
163 Switch transistor
164 Reset transistor
165 Amplifier transistor
166 Selection transistor
167 First storage transistor
168 Second storage transistor
181 Connection transistor
201 Color filter
202 On-chip microlens
211-1, 211-2 Photodiode
212 Inter-pixel isolation part
221 Inter-wiring layer film
222 Wiring
231 MIM capacitive element
232 MIM capacitive element
261 Transfer transistor
262,269 FD
263 Switch transistor
264 Reset transistor
265 Amplifier transistor
266 Selection transistor
267 Switch transistor
268 Storage transistor
1000 Electronic device

## Claims

1. A solid-state imaging device comprising:
a plurality of pixels that each include a photoelectric conversion element and a plurality of wiring capacitive elements; and
a read-out unit that reads out signals from the plurality of pixels, wherein the solid-state imaging device has a structure that a charge having overflown from the photoelectric conversion element is stored in a first wiring capacitive element, and the charge having overflown from the first wiring capacitive element is stored in a second wiring capacitive element, and
the read-out unit individually reads out a signal of each of the photoelectric conversion element, the first wiring capacitive element, and the second wiring capacitive element.

2. The solid-state imaging device according to claim 1, wherein the first wiring capacitive element and the second wiring capacitive element are disposed between different wiring layers.

3. The solid-state imaging device according to claim 1, wherein the first wiring capacitive element and the second wiring capacitive element are a first MIM capacitive element and a second MIM capacitive element having different capacitances.

4. The solid-state imaging device according to claim 3, wherein the first MIM capacitive element and the second MIM capacitive element have structures whose at least ones of film types, thicknesses, and areas of dielectrics are different.

5. The solid-state imaging device according to claim 4, wherein the first MIM capacitive element and the second MIM capacitive element have three-dimensional structures.

6. The solid-state imaging device according to claim 5, wherein the solid-state imaging element has a structure that the charge having overflown from the photoelectric conversion element overflows to the first wiring capacitive element from an overflow path different from a path of a transfer gate that transfers the charge stored in the photoelectric conversion element.

7. A solid-state imaging device comprising:
a plurality of pixels that each include a plurality of photoelectric conversion elements and a plurality of wiring capacitive elements; and
a read-out unit that reads out signals from the plurality of pixels, wherein
the solid-state imaging device has a structure that a first wiring capacitive element and a second wiring capacitive element are respectively connected to floating diffusions of a first photoelectric conversion element and a second photoelectric conversion element, and a charge having overflown from the first photoelectric conversion element is stored in the first wiring capacitive element, and the charge having overflown from the second photoelectric conversion element is stored in the second wiring capacitive element, and
the read-out unit individually reads out a signal of each of the first photoelectric conversion element, the second photoelectric conversion element, the first wiring capacitive element, and the second wiring capacitive element.

8. The solid-state imaging device according to claim 7, wherein the first wiring capacitive element and the second wiring capacitive element are disposed between different wiring layers.

9. The solid-state imaging device according to claim 7, wherein the first wiring capacitive element and the second wiring capacitive element are a first MIM capacitive element and a second MIM capacitive element having different capacitances.

10. The solid-state imaging device according to claim 9, wherein the first MIM capacitive element and the second MIM capacitive element have structures whose at least ones of film types, thicknesses, and areas of dielectrics are different.

11. The solid-state imaging device according to claim 10, wherein the first MIM capacitive element and the second MIM capacitive element have three-dimensional structures.

12. The solid-state imaging device according to claim 7, wherein the first photoelectric conversion element and the second photoelectric conversion element have different sensitivities.
